Europäisches Patentamt

European Patent Office

Office européen des brevets

(11) Veröffentlichungsnummer: **0 243 630**
A1

## (12) EUROPÄISCHE PATENTANMELDUNG

(21) Anmeldenummer: 87103425.2

(22) Anmeldetag: **10.03.87**

(51) Int. Cl.4: **G01R 15/02** , G01R 33/06

(30) Priorität: 26.04.86 DE 3614236

(43) Veröffentlichungstag der Anmeldung:
**04.11.87 Patentblatt 87/45**

(84) Benannte Vertragsstaaten:
**DE FR GB IT SE**

(71) Anmelder: **VDO Adolf Schindling AG
Gräfstrasse 103
D-6000 Frankfurt/Main(DE)**

(72) Erfinder: **Porth, Wolfgang
Röhrborngasse 70
D-6000 Frankfurt am Main(DE)**
Erfinder: **Weibler, Wolfgang, Dr.
Vor der Heide 14
D-6238 Hofheim a. T.(DE)**

(74) Vertreter: **Klein, Thomas, Dipl.-Ing. (FH)
Sodener Strasse 9 Postfach 6140
D-6231 Schwalbach a. Ts.(DE)**

(54) **Anordnung zur berührungslosen Messung des elektrischen Stroms in einem Leiter.**

(57) Bei einer Anordnung zur berührungslosen Messung des elektrischen Stroms in einem Leiter, bei welcher ein den Leiter umschließender Magnetkern (3) einen Spalt aufweist, in welchem ein Magnetfeldsensor (9) angeordnet ist, ist der Spalt an den Rändern (6, 7) gegenüber einem mittleren Bereich (5) verengt.

FIG. 2

EP 0 243 630 A1

## Anordnung zur berührungslosen Messung des elektrischen Stroms in einem Leiter.

Die Erfindung betrifft eine Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist.

Derartige Anordnungen werden zur Strommessung verwendet, wenn beispielsweise eine galvanische Trennung zwischen dem zu messenden Strom und einem Meßstromkreis erfolgen soll oder wenn in den Stromkreis kein Widerstand eingefügt werden soll, welcher den Abfall einer Meßspannung bewirkt. Letzteres ist insbesondere bei elektrischen Anlagen von Kraftfahrzeugen der Fall, wo relativ hohe Ströme bei geringen Spannungen auftreten. Bei den bekannten Anordnungen für diesen Zweck ist jedoch die Querschnittsfläche größer als die aktive Fläche des Magnetfeldsensors. Dadurch gehen magnetische Kraftlinien für die Auswertung des Kraftfeldes im Magnetfeldsensor verloren, was zu einer geringen Empfindlichkeit derartiger Anordnungen führt.

Aufgabe der vorliegenden Erfindung ist es, eine Anordnung zur berührungslosen Messung des elektrischen Stroms in einem Leiter anzugeben, bei welchem bereits bei geringem Strom eine auswertbare Spannung am Magnetfeldsensor entsteht.

Die erfindungsgemäße Anordnung ist dadurch gekennzeichnet, daß der Spalt an den Rändern gegenüber einem mittleren Bereich verengt ist. Dadurch wird eine Homogenisierung des Magnetfeldes innerhalb des Spaltes erreicht. Das Sensorelement, üblicherweise wesentlich kleiner als die Breite des Magnetkerns, wird dadurch quer zu den Feldlinien frei verschiebbar, ohne daß sich die Empfindlichkeit der Anordnung ändert. Das wirkt sich positiv auf die Fertigung und die mechanische Unempfindlichkeit der Anordnung aus.

Die Erfindung läßt zahlreiche Ausführungsformen zu. Eine davon ist schematisch in der Zeichnung an Hand mehrerer Figuren dargestellt und nachfolgend beschrieben. Es zeigt:

Fig. 1 eine Ansicht einer erfindungsgemäßen Anordnung und

Fig. 2 eine vergrößerte Schnittdarstellung des Polbereichs der Anordnung nach Fig. 1.

Gleiche Teile sind in den Figuren mit gleichen Bezugszeichen versehen.

Ein gestrichelt dargestellter Leiter 1 tritt durch eine Öffnung 2 eines Magnetkerns 3 hindurch. Ein Magnetfeldsensor 4 ist in einem Spalt 5 des Magnetkerns 3 angeordnet. Ein durch den Leiter 1 fließender Strom verursacht ein kreisförmiges Magnetfeld, das durch den Magnetkern 3 geführt wird.

Die Kraftlinien schließen sich über einen Spalt 5, wo sie in dem Magnetfeldsensor in an sich bekannter Weise eine dem Strom etwa proportionale Spannung zur Folge haben.

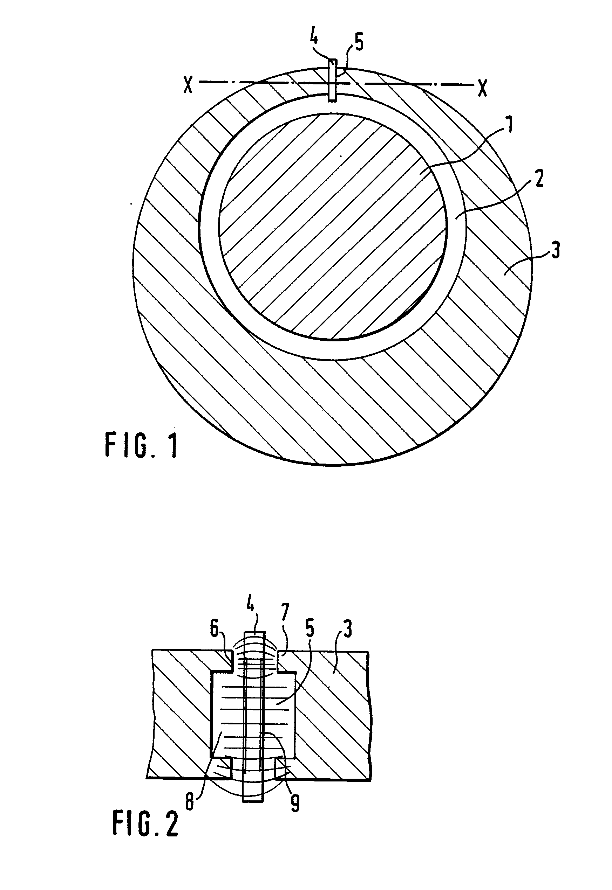

Fig. 2 stellt vergrößert einen Teil des Schnittes durch die Anordnung nach Fig. 1 an der Linie X - X dar. Gemäß der Erfindung ist der Spalt 5 des Magnetkerns 3 an den Rändern 6, 7 gegenüber dem mittleren Bereich 8 verengt. In der unteren Hälfte der Figur ist der Verlauf der Kraftlinien ohne die erfindungsgemäßen Verengungen 6, 7 dargestellt, während die obere Hälfte der Figur 2 den Verlauf der Kraftlinien bei der erfindungsgemäßen Anordnung zeigt. Es ist ohne weiteres ersichtlich, daß eine Homogenisierung des Feldes innerhalb der in Fig. 2 durch stärkere Linien hervorgehobenen aktiven Fläche 9 des Magnetfeldsensors 4 auftritt.

## Ansprüche

Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist, dadurch gekennzeichnet, daß der Spalt (5) an den Rändern (6, 7) gegenüber einem mittleren Bereich (8) verengt ist.

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 036 935 (IBM) <br> * Anspruch 1; Figur 1 * <br><br> --- | 1 | G 01 R 15/02 <br> G 01 R 33/06 |
| A | GB-A-2 158 642 <br> (TELEFONAKTIEBOLAGET L.M. ERICSSON) <br> * Seite 1, Zeile 99 - Seite 2, Zeile 30, Figur 4 * <br><br> ----- | 1 | |

| | RECHERCHIERTE SACHGEBIETE (Int. Cl.4) |
|---|---|
| | G 01 R 15/02 <br> G 01 R 33/06 |

Der vorliegende Recherchenbericht wurde für alle Patentansprüche erstellt.

| Recherchenort | Abschlußdatum der Recherche | Prüfer |
|---|---|---|
| BERLIN | 29-06-1987 | LEMMERICH J |